(19) **Europäisches Patentamt**

**European Patent Office**

**Office européen des brevets**

(11) **EP 1 098 447 B1**

(12) **EUROPEAN PATENT SPECIFICATION**

(45) Date of publication and mention
of the grant of the patent:
**22.02.2006 Bulletin 2006/08**

(51) Int Cl.:
*H03M 7/40* (2006.01)      *H03M 13/00* (2006.01)

(21) Application number: **00203909.7**

(22) Date of filing: **08.11.2000**

(54) **Combined channel and entropy decoding**

Kombinierte Kanal - und Entropiedekodierung

Décodage combiné de canal et d'entropie

(84) Designated Contracting States:
**AT BE CH CY DE DK ES FI FR GB GR IE IT LI LU MC NL PT SE TR**

(30) Priority: **08.11.1999 US 164063 P**

(43) Date of publication of application:
**09.05.2001 Bulletin 2001/19**

(73) Proprietor: **TEXAS INSTRUMENTS INCORPORATED**
**Dallas,**
**Texas 75251 (US)**

(72) Inventor: **Yamaguchi, Hirohisa**
**Tsukuba 350-0035 (JP)**

(74) Representative: **Holt, Michael**
**Texas Instruments Limited,**
**European Patents Department (MS 13),**
**PO Box 5069**
**Northampton NN4 7ZE (GB)**

(56) References cited:

- WEN J ET AL: "Utilizing soft information in decoding of variable length codes" DATA COMPRESSION CONFERENCE, PROCEEDINGS DCC 99, IEEE COMPUTER SOCIETY PRESS, LOS ALAMITOS, CA, US, 29 March 1999 (1999-03-29), pages 131-139, XP002143233
- MASSEY J.L.: "Variable-length codes and the Fano metric" IEEE TRANSACTIONS ON INFORMATION THEORY, vol. 18, no. 1, January 1972 (1972-01), pages 196-198, XP002243315
- HAGENAUER J ET AL: "Iterative decoding of binary block and convolutional codes" IEEE TRANSACTIONS ON INFORMATION THEORY, IEEE INC. NEW YORK (US), vol. 42, no. 2, March 1996 (1996-03), pages 429-445, XP000850507 ISSN: 0018-9448
- KOPANSKY A. AND BYSTROM M.: "Sequential decoding of MPEG-4 coded bitstreams for error resilience" CONFERENCE ON INFORMATION SCIENCES AND SYSTEMS, BALTIMORE, MARYLAND, PROCEEDINGS CISS 99, 17 - 19 March 1999, XP002243316
- SUBBALAKSHMI K P ET AL: "Joint source-channel decoding of entropy coded Markov sources over binary symmetric channels" IEEE INTERNATIONAL CONFERENCE ON COMMUNICATIONS. PROCEEDINGS ICC 99, VANCOUVER, CA, NEW YORK, IEEE INC. NEW YORK (US), vol. 1, 6 June 1999 (1999-06-06), pages 446-450, XP002143232 ISBN: 0-7803-5285-8
- BALAKIRSKY V B: "Joint source-channel coding with variable length codes" IEEE INTERNATIONAL SYMPOSIUM ON INFORMATION THEORY, ULM, GERMANY, PROCEEDINGS ISIT 97, IEEE INC. NEW-YORK (US), 29 June 1997 (1997-06-29) - 4 July 1997 (1997-07-04), page 419 XP010239935 ISBN: 0-7803-3956-8
- DEMIR N ET AL: "Joint source/channel coding for variable length codes" DATA COMPRESSION CONFERENCE, PROCEEDINGS. DCC 98, IEEE COMPUTER SOCIETY PRESS, LOS ALAMITOS, CA, US, 30 March 1998 (1998-03-30), pages 139-148, XP002143231

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

Printed by Jouve, 75001 PARIS (FR)

**Description**

Field of Invention

This invention relates to digital communications and, more particularly, to channel and entropy coding.

Background of Invention

In digital communication, source information is quantized into bits and entropy-coded into code-words of variable length. This process is generally called redundancy reduction in speech, still image and video. See A.K. Jain, "Fundamentals of Digital Image Processing," published by Prentice Hall, 1989. The entropy-coded symbols are added with controlled amount of redundancy, which is generally called channel-coding. See R.E. Ziemer and W.H. Tranter, "Principles of Communication Systems, Modulation and Noise," published by Houghton Mifflin, 1995. The resultant sequence of binary data is converted into analog, modulated and transmitted on an RF carrier.

The received signal is demodulated into base-band signal, which is again converted into digital for channel decoding, through which, using the redundancy added at the transmission side, errors that occurred are corrected. The resultant sequence of binary data is then decoded into source code-words by mapping binary data segment into an element of a variable code.

In the standard implementation of a communication system, channel decoding and entropy decoding are treated as separate function blocks because their counterparts, entropy encoding and channel encoding, are treated separately.

In the paper "Utilizing soft information in decoding of variable length codes" by Wen, J. and Villasenor, J.D. (Proc. IEEE Data Compression Conf., Snowbird, Utah, March 1999, pp. 131-139) there is described an approach of decoding a sequence of variable length code words forming a packet of known length. The used metric is based on the probability information associated with each bit either by direct use of channel observations or through soft-output channel decoders. However, if the number of variable length code words in a packet increases it becomes nearly impossible to decode.

In the paper by Massey, J.L., "Variable-length codes and the Fano metric", (IEEE Trans. On Information Theory, Vol.IT-18, No. 1, Jan. 1972, pp. 196-198), the authors discuss the optimal log-likelihood metric together with an approximation thereof for minimum-error probability decoding of variable length codes.

Summary of Invention

The present invention provides digital communication apparatus as set forth in the claims.

Description of Drawings

The Exemplary embodiments of the present invention will now be described in detail with reference to the accompanying drawings in which:

FIG. 1 illustrates a typical prior art communication system;
FIG. 2 illustrates a Turbo encoder according to the prior art;
FIG. 3 illustrates the structure of the Turbo encoder of FIG. 2;
FIG. 4 illustrates the structure of the Soft-Output-Viterbi or MAP decoder used for the Turbo decoder;
FIG. 5 is a plot of examples of code-word likelihood values versus code word number;
FIG. 6 illustrates a diagram of the new channel-entropy decoder according to one embodiment of the present invention; and
FIG. 7 illustrates likelihood computation by look-ahead decoding.

Description of Exemplary Embodiments of the Present Invention

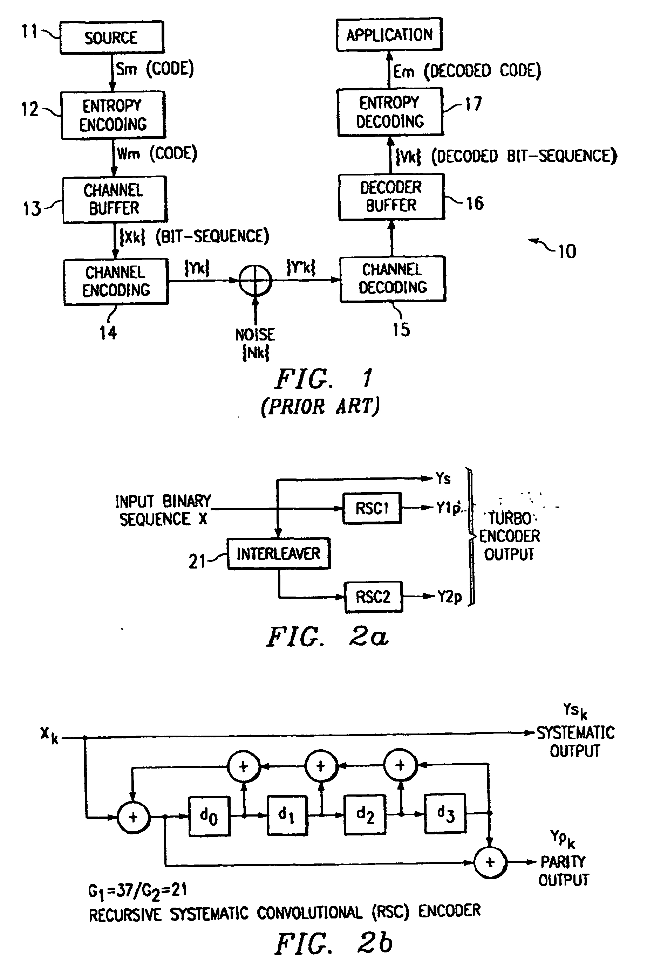

In order to explain the new invention, Applicants refer to the typical communication system of FIG. 1 and discuss convolution coding and Turbo encoder and a Soft-Output Viterbi or MAP decoder.

FIG. 1 illustrates a typical communication system 10. First the source 11 is regarded as generating a symbol Sm out of a given set of source alphabet symbols. The source output symbol is then one-to-one mapped to a variable length code Wm.

The entropy-coded symbols are buffered at buffer 13 and added with a controlled amount of redundancy at channel encoding 14 to get output Yk. In a typical system, the received input Y' k is channel decoded 15 and the buffered output at buffer 16 is entropy decoded at decoder 17. In actual entropy coding, a number of variable-length code sets are needed and used to represent the source information in the smallest number of bits. Because the new implementation discussed here will be easily extended to general cases as explained later, we will regard entropy coder 12 as consisting only one set of variable-length codes. Then corresponding to Sm, one variable length code Wm is chosen from the set of channel codes Z (Wm∈ Z).

Table 1 shows an example of variable-length codes- Values in the table represent the set of source symbols and the codes correspond to the set Z above. Output code bits from the entropy coder 12 are concatenated sequentially. When this binary sequence (Y'k) arrives at the receiver without error, the original input source symbols can be decoded by tracing sequential 0 and 1 bits because codes are defined to allow this decoding unique.

Table 1

| value (code #) | binary code |
| --- | --- |
| 1 | 00 |
| 2 | 010 |
| 3 | 1110 |
| 4 | 11110 |
| 5 | 111110 |
| 6 | 1111110 |
| 7 | 11111110 |
| 8 | 111111110 |

This particular set of codes in Table 1 is used to encode the differential DC signal in the JPEG standard. 0 is replaced by -1 in the coding and decoding.

In a system with convolution coding and, in particular, a Turbo encoder 14, the output of the Turbo decoder 15 is a binary sequence. The output bit sequence of the channel decoder 15 can have bit errors. The effect of these bit errors on the entropy decoder 17 is very serious because variable-length coding assumes that previous bit-sequence has been correctly decoded. When a bit error occurs, either a wrong code-word is selected or no corresponding code-word is found in the code-word set. In conventional variable-length code decoding, the decoding process is terminated at such point and some other means is sued to prevent catastrophic signal degradation. It is empirically known that once a bit-error occurs during the variable-length code decoding, no effective means exists to recover the decoding process unless a number of special and unique codes are inserted in the bit sequence.

For the channel coding 14, we pick the convolutional coding which is commonly used for the wired and wireless communication. For convolution encoding, see R.L. Peterson, R.E. Ziemer, and D.E. Borth, entitled "Introduction to Spread Spectrum Communications," Prentice Hall, 1995. In the convolutional coding, one input bit information is repeated a number of times using elaborate feedback or feed-forward loop. The ratio of the input number of bits with respect to the output bits is called the rate of the convolutional code. In the following, we select Turbo coding for channel encoding 14 that uses feedback (recursive systematic coding) with rate 1/3. Referring to FIG. 2(a), from the input binary sequence x, three output sequences Ys, Y1p and Y2p are generated using Recursive Systematic Convolution (RSC) encoders RSC1 and RSC2. The convolution encoder used for Turbo coding has rate = 2/3, constraint length =5. The Ys is the systematic output and Y1p and Y2p are parityoutputs. An example of the structure of Recursive Systematic Convolution Encoders RSC1 and RSC2 is shown in FIG. 2(b). The interleaver 21 is used to uncorrelate the binary input sequence for RSC1 and RSC2. Output Y is exactly the same copy of the input binary sequence. The convolution encoder 14 introduces an infinite-length correlation in parity outputs. For Turbo encoding, see C. Berrou and A. Glavieux, "Near Optimum Error Correcting Codes and Decoding Turbo Codes," *IEEE Transactions on Communications,* Vol. 44, no. 10, October, 1996. The same argument is also valid for the standard convolutional encoding that employs Viterbi decoding. The net channel encoding rate can be further improved by alternatively dropping the parity bit, Y1p and Y2p, while Ys is sent without dropping. In this case, the encoding rate becomes 1/2 instead of 1/3. This process is generally called puncturing. We will henceforth assume that such puncturing is performed at transmitter but this is not an essential assumption.

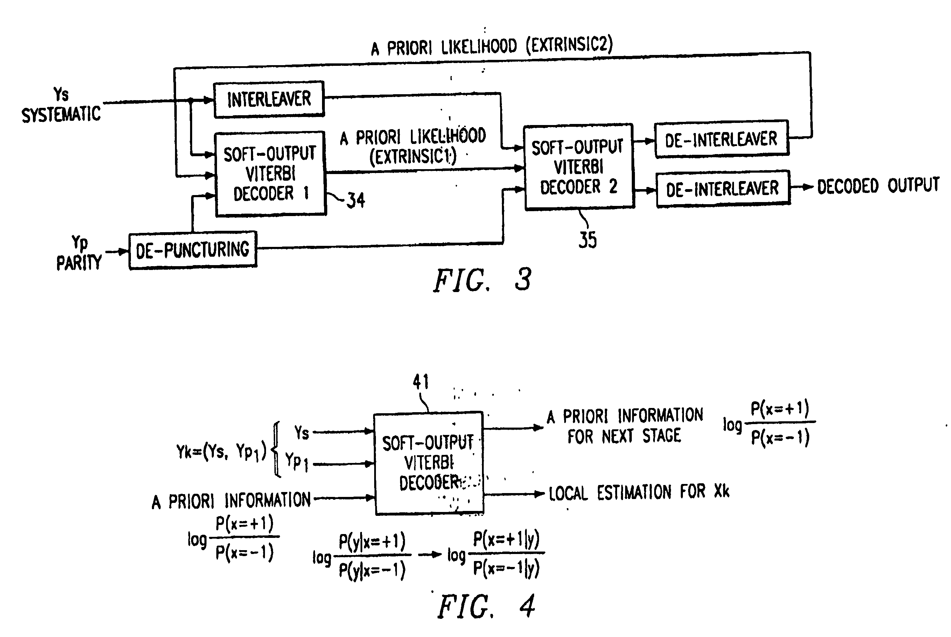

FIG. 3 shows the structure of Turbo decoder 15 corresponding to the encoder shown in FIG. 2. We will denote the receiver Y'k in FIG. 1 simply as Yk in the following for simplicity. Due to the puncturing at the transmitter, 0 bit is inserted alternately to complement the missing bits in Y1p and Y2p sequences (de -puncturing). There are two basic decoders 34 and 35 each one of which is called Soft-Output Viterbi Decoder (SOVA) or Maximum A Posteriori Likelihood Decoder (MAP). *See also* J. Hagenauer, E. Offer and L. Papke, "Iterative Decoding of Binary Block and Convolution Codes," *IEEE Trans. on Information Theory,* Vol. 42, no. 2, March 1996. Viterbi decoder is widely known as the maximum a posteriori probability estimator for the original input binary sequence. It uses the available Ys and Y1p, or Ys and Y2p (with interleaving) and is known to provide optimum channel decoder performance.

Using the probability theory, it can be shown that the best channel decoder maximizes the following a posteriori probability of input Xk using the received Yk (see FIG. 1).

$$P(X_k|Y_k) = \frac{P(X_k, Y_k)}{P(Y_k)} = \frac{P(Y_k|X_k)P(X_k)}{P(Y_k)} \qquad \text{EQ.(2)}$$

In EQ.(2), Bayes rule was used to represent the a posteriori probability P(Xk|Yk) by the a priori probability P(Yk|Xk) and the prior probabilities P(Xk) and P(Yk). *See* W.B. Davenport and W.J. Root, "An Introduction to the Theory of Random Signals and Noise," McGraw Hill, 1958. In order to estimate Xk by Yk with respect to the possible value of -1 and +1, comparison of P(Xk = -1|Yk) and P(Xk = +1|Yk) is made in logarithm as follows:

$$L(x|y) = \log \frac{P(x=+1|y)}{P(x=-1|y)} = \log \frac{P(y|x=+1)}{P(y|x=-1)} + \log \frac{P(x=+1)}{P(x=-1))} \qquad \text{EQ.(3)}$$

This ratio is called the log likelihood ratio or simply the likelihood ratio. When the noise Nk in FIG. 1 is Gaussian white noise, P(y|x=+1) is shown to be

$$\text{EQ.(4)}$$

$$P(y|x=+1) = \frac{1}{\sqrt{2\pi\sigma^2}} e^{-\frac{(r-a)^2}{2\sigma^2}}$$

Where $\sigma^2$ is

$$\text{EQ (5)}$$

$$\sigma = \left(\frac{E_s}{N_0}\right)^{-1}$$

and Es, symbol power, is given by Eb/R. Eb represents the signal power per one bit of information and R is the coding rate. Also, a in EQ.(4) stands for the channel fading phenomenon, but this is not essential in present discussion. Hence, a=1 is assumed in the following. In terms of these probabilities, the Viterbi or MAP decoder in FIG. 3 computes the a priori likelihood of p(Xk) from the available likelihood information as shown in FIG. 4.

Referring to FIG. 4, decoder 41 (34 or 35) generates a priori information p(Xk) from Ys and Yp1 (or Yp2). If there exists a priori information p(Xk) available together with Ys, it is also taken into account as shown above. Decoder 41 can also generate the local estimate for Xk.

Fig. 3 shows that a priori information of the first stage decoder 34 is subsequently used as an input to the second Viterbi or MAP decoder 35 and at the same time, the a priori information of the second decoder 35 is fed-back to the first decoder 34. Thus, when the a priori information passed to the next decoders is carefully defined in the way that such process improves the estimation accuracy of the original Xk, it is shown that the estimated Xk converges to the original Xk as the feedback is repeated.

In conventional communication system, output of the Turbo decoder is a binary sequence. This sequence is generated by applying the hard-decision to the a posteriori likelihood value of the Turbo decoder.

$$\log\frac{P(x=+1|y)}{P(x=-1|y)} > 0 \rightarrow x = +1$$

$$\log\frac{P(x=+1|y)}{P(x=-1|y)} \leq 0 \rightarrow x = -1$$

EQ.(6)

The output bit sequence of the channel decoder contains bit-errors. In general, the bit-error rate (BER) of 10E-3 to 10E-4 is required for the real-time speech and video communication. Quality of the channel is maintained by controlling the transmission signal power.

The effect of these bit errors on the entropy decoder (17 in FIG. 1), however, is very serious because variable-length coding assumes that previous bit-sequence has been correctly decoded. When a bit error occurs, either a wrong code-word is selected or no corresponding code-word is found in the code-word set. In conventional variable-length code decoding, the decoding process is terminated at such point and some other means is used to prevent catastrophic signal degradation. It is empirically known that once a bit-error occurs during the variable-length code decoding, no effective means exists to recover the decoding process unless a number of special and unique codes are inserted in the bit-sequence. According to the present invention, it is shown that by combining the channel decoder (Turbo or Viterbi decoder) 15 with the entropy (variable-length) decoder 17, a significant improvement is achieved in the bit-error rate.

In the communication receiver, input signal to the Viterbi decoder 15 can be quantized into bits (hard-decision) or into multi-levels (soft-decision). It has been widely known that soft-decision Viterbi decoder achieves a significant improvement compared with the hard-decision decoder. This is because likelihood of the input signal is preserved in the multi-level information and it is lost in the hard-decision decoder. Similar observation can be applied to the channel and the entropy decoder. Conventional entropy decoder 17 receives hard-decision bits from the channel decoder 15. However, when the likelihood information is passed to the entropy decoder 17, a significant improvement is also possible. From FIGS. 3 and 4, it is seen that such likelihood information can be provided in form of the a priori information from the Viterbi or MAP decoder 15 (34 and 35 of FIG. 3).

There are two approaches to take advantage of such information in the decoding. One is very simple and the other is significantly more powerful but more complex to implement.

(1) Simple realization of the combined channel 15 and entropy decoder 17

We assume that the decoding starts from a correct bit position. We use, instead of the bit data, the likelihood values from the channel decoder and compute the code-word likelihood for all the code-words in the set. Code-word likelihood can be defined by

$$P^{(m)} = \sum_{k=0}^{N_m-1} c_k l_k$$

EQ.(7)

where $N_m$ is the length of the code, m denotes the m-th code-word in the set, $c_k$ (k=0,,,$N_m$) represents the code-word bit-sequence (0 and 1 need be mapped to -1 and 1) and $l_k$ the likelihood values obtained form the channel decoder. For Table 1, eight code-word likelihood values are obtained.

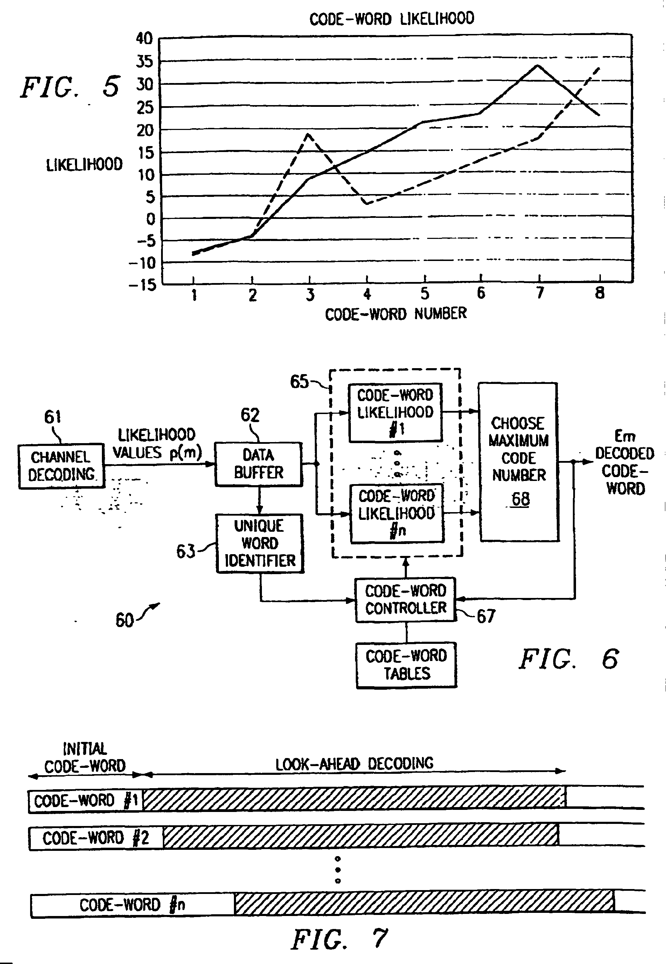

There are many variations of algorithms for choosing the best code-word. One approach introduced here is to find the local maxima in the likelihood value (code-word #3 and #7 are thus found in FIG. 5) as the decoded code-word. This algorithm has been found better than choosing the simple maximum. This comes from the characteristic of the code-word likelihood that it monotonically increases as far as bits are correctly decoded but it turns into a random walk when it is not matched any more.

For example, consider the actual case in which the conventional decoding has failed:
From the channel decoder, the bit-sequence [111001111---] has been obtained. Using Table 1, the code-word #3 [1110] is chosen, but the correct coded-word was #4. Now we get the likelihood values from the channel decoder:
[4.9, 4.3, 3.8, -0.3, -5.0, 4.5, 4.1, 5.4, 2.4,---]
which corresponds to [111001111 ---] Now the code-word likelihood values are computed;

[-9.2, -4.4, 13.2, 17.7, 3.1, 8.1, 10.9, 19.2]

Here we can observe that there exists a local maxima at code-word #4 and another large value at code-word #8. In general, code-word likelihood monotonically increases for longer code length. This needs to be taken into account by biasing the local maxima search according to the code-length. By this algorithm, the correct code-word #4 corresponding to the local maxima can be chosen. FIG. 5 shows two other examples of code-word likelihood versus code-word number obtained using the variable-length codes of Table 1.

Computer simulation has been made to study the performance of the new decoding method. Communication channel has been defined as shown in FIG. 1. Variable-length codes of Table 1 were used, from which code-word was selected at random and the corresponding bit-sequence was then convolutional-coded using Turbo encoder (rate 1/2 and constraint length 5), added with white noise and then Turbo decoded. Turbo decoder has been controlled (by feed-back repetition number) so that the output decoded BER becomes 10E-3. Likelihood values were then used for the variable-length decoder and the new decoding has been compared with the conventional bit-wise hard-decision variable-length decoding. As the result, by using the simple rule explained in FIG. 5, it has been observed that bit errors can be reduced to 1/3 to 1/5 in number. By studying elaborate algorithms, it appears that 1/10 reduction would be achievable.

FIG. 6 also shows other related functions needed in the practical system. Output from the channel decoder (likelihood values) 61 are stored in buffer 62. Before the variable-length decoding starts, a unique code word (start code) is searched in either the bit pattern or in the likelihood value at the unique word identifier 63. When the unique word is found, candidate code-words are loaded into separate code-word likelihood computation units #1 through n inside the dotted block 65. Each unit #1 through n computes EQ.(7) for the given code-word bit-pattern. In actual implementation, a number of variable-length and fixed length code sets are used according to the coding syntax. Hence, in order to find all the code-word candidates, a number of different code sets are referenced and loaded as the candidate codes. A search algorithm that has been tested follows:

(a) Compute the code-word likelihood for all the code length (starting with m=2 and ending with m=9). If there is a drop in the code-word likelihood value, count it as a candidate word. For example, the code-word likelihood for m=2 was 1.3, m=3 was 2.5 and m=4 was 2.2, so on, then m=3 code-word is taken as a candidate. When multiple codes correspond to the same word-length, compute the likelihood and judge if there is one that causes such phenomenon. If there is no such phenomenon and the likelihood value increases monotonically, decode word is the first 2-bit code.

(b) Choose the code that causes the (relative to the code length) largest drop in the likelihood value.

When the code-word has been chosen 68 by comparing the code-word likelihood values, the selected maximum value code information is fed-back to the code-word controller 67 to proceed to the next-step decoding. The decoded code-word $E_m$ is provided out of the decoder. When the decoding collapses, the unique word search process needs to be started again.

(2) Improved performance implementation by one-word look-ahead.

This approach is only applicable to the variable length codes. When a decoding error occurs, the next code-word can become an error. Hence, by computing the next code-word likelihood and verifying the existence of legitimate code word, some improvement is possible. Extension of this idea leads to the following implementation.

(3) More powerful but more complex implementation.

Decoding by considering the future code-word likelihood is explained by FIG. 7.

The initial code words are the same ones considered in FIG. 6. The likelihood decoding is continued (in the best-effort method as discussed in (1)). The extended decoding is continued until the total decoded bit-length exceeds a given threshold. Because of the variable code-lengths, extended code-lengths also vary, but as we extend the decoding length long enough, the total code-lengths become nearly of an equal length. Code-word likelihood values are compared between these extended code-words and the probability that the correct code-word sequence is decoded rapidly increases as the extended code-length is increased. The complexity of the decoder increases likewise and a compromise needs to be made. Structure of the decoder is the same as FIG. 6 and, thus, is omitted.

Using likelihood values instead of bits, a new combined channel (Turbo or Viterbi decoder) and entropy decoder implementation has been discussed. It has been shown that a significant improvement is achieved in BER by the new method. System structure implementing the new decoder has been discussed for two approaches; simple implementation and more powerful, but more complex, implementation.

**Claims**

1. A digital communication system for decoding source information quantized into bits, entropy-coded into code words of variable length and channel coded, the system comprising a receiver including a channel decoder (61), an entropy decoder and means (62) (63) for applying a code word to said entropy decoder wherein said entropy decoder comprises means (65) for computing code word likelihood values for all code words in a set assuming starting at the correct bit position **characterized in that** said entropy decoder further comprises

   means (67) (68) for choosing the best code words in the set by finding the local maxima in the code word likelihood values.

2. The system of Claim 1, wherein said means for computing code word likelihood values is adapted to operate according to $P^m = \sum_{k=0}^{N_m-1} c_k l_k$ , where $N_m$ is the length of the code, $m$ denotes the $m^{th}$ code word in the set, $c_k$ ($k=0, ..., N_m$) represents the code-word bit sequence and $l_k$ the likelihood values obtained from the channel decoder.

3. The system of Claim 1 or Claim 2, wherein the channel decoder is a Viterbi or MAP decoder.

**Patentansprüche**

1. Digitales Kommunikationssystem zum Decodieren von Quellinformationen, die in Bits quantisiert sind, in Codewörter mit variabler Länge entropiecodiert sind und kanalcodiert sind, wobei das System einen Empfänger umfasst, der einen Kanal-Decodierer (61), einen Entropie-Decodierer und Mittel (62, 63) zum Eingeben eines Codewortes in den Entropie-Decodierer enthält, wobei der Entropie-Decodierer Mittel (65) umfasst, um Codewort-Wahrscheinlichkeitswerte für alle Codewörter in einer Menge unter der Annahme, dass bei der richtigen Bitposition begonnen wird, zu berechnen, **dadurch gekennzeichnet, dass** der Entropie-Decodierer ferner Mittel (67, 68) umfasst, die die besten Codewörter in der Menge durch Suchen der lokalen Maxima in den Codewort-Wahrscheinlichkeitswerten auswählen.

2. System nach Anspruch 1, bei dem die Mittel zum Berechnen von Codewort-Wahrscheinlichkeitswerten so beschaffen ist, dass sie gemäß $P^m = \sum_{k=0}^{N_m-1} c_k l_k$ arbeiten, wobei $N_m$ die Länge des Codes ist, m das m-te Codewort in der Menge bezeichnet, $c_k$($k = 0, ..., N_m$) die Codewort-Bitfolge repräsentiert und $l_k$ die von dem Kanal-Decodierer erhaltenen Wahrscheinlichkeitswerte repräsentiert.

3. System nach Anspruch 1 oder Anspruch 2, bei dem der Kanal-Decodierer ein Viterbi- oder MAP-Decodierer ist.

**Revendications**

1. Système de communication numérique pour décoder des informations de source quantifiées en bits, codées par entropie en mots de code de longueur variable et codées par canal, le système comprenant un récepteur comprenant un décodeur de canal (61), un décodeur entropique et des moyens (62) (63) pour appliquer un mot de code au dit décodeur entropique, dans lequel ledit décodeur entropique comprend un moyen (65) pour calculer des valeurs de vraisemblance de mot de code pour tous les mots de code dans un ensemble supposé commencer à la position de bit correcte **caractérisée en ce que** ledit décodeur entropique comprend en outre :

   des moyens (67) (68) pour choisir les meilleurs mots de code dans l'ensemble en trouvant les maxima locaux dans les valeurs de vraisemblance de mot de code.

2. Système selon la revendication 1, dans lequel ledit moyen pour calculer des valeurs de vraisemblance de mot de code est adapté pour fonctionner selon $P^m = \sum_{k=0}^{N_m-1} c_k l_k$ , où $N_m$ est la longueur du code, m désigne le $m^{ième}$ mot de code dans l'ensemble, $c_k(k=0, ..., N_m)$ représente la séquence binaire de mot de code et $l_k$ les valeurs de vraisemblance obtenues à partir du décodeur de canal.

3. Système selon la revendication 1 ou la revendication 2, dans lequel le décodeur de canal est un décodeur Viterbi ou MAP.

11 SOURCE

Sm (CODE)

12 ENTROPY ENCODING

Wm (CODE)

13 CHANNEL BUFFER

{Xk} (BIT-SEQUENCE)

14 CHANNEL ENCODING

{Yk}

NOISE {Nk}

{Y'k}

APPLICATION

Em (DECODED CODE)

ENTROPY DECODING 17

{Vk} (DECODED BIT-SEQUENCE)

DECODER BUFFER 16

CHANNEL DECODING

15

10

## FIG. 1
## (PRIOR ART)

INPUT BINARY SEQUENCE X

→ Ys

RSC1 → Y1p

21 INTERLEAVER

RSC2 → Y2p

TURBO ENCODER OUTPUT

## FIG. 2a

$X_k$ → $Ys_k$ SYSTEMATIC OUTPUT

$d_0$  $d_1$  $d_2$  $d_3$

$Yp_k$ PARITY OUTPUT

$G_1 = 37 / G_2 = 21$
RECURSIVE SYSTEMATIC CONVOLUTIONAL (RSC) ENCODER

## FIG. 2b

FIG. 3

FIG. 4

## CODE-WORD LIKELIHOOD

FIG. 5

FIG. 6

FIG. 7